# EUROPEAN PATENT SPECIFICATION

(11) **EP 0 719 451 B1**
(45) Date of publication and mention of the grant of the patent: **16.10.2002**
(21) Application number: 95923491.5
(22) Date of filing: 04.07.1995
(51) Int. Cl.: H01L 21/3205, H01L 21/44

(54) **FILLING HOLES AND THE LIKE IN SUBSTRATES**
FÜLLEN VON LÖCHERN UND DERGLEICHEN IN SUBSTRATEN
REMPLISSAGE DE TROUS ET ANALOGUE DANS DES SUBSTRATS

(30) Priority: 13.07.1994 GB 9414145
(43) Date of publication of application: 03.07.1996
(60) Divisional application: 01116591.7
(73) Proprietor: Trikon Technologies Limited, Newport, Gwent NP6 2TA (GB)
(72) Inventor: DOBSON, Christopher, David, Olveston Bristol BS12 3AA (GB); McGEOWN, Arthur, John, Bristol BS6 6XB (GB)
(74) Representative: Dunlop, Brian Kenneth Charles
(86) International application number: GB9501572
(87) International publication number: WO96002938

(56) References cited:
- EP-A- 0 143 742
- EP-A- 0 417 570
- EP-A- 0 516 344
- WO-A-94/13008
- DE-A- 4 020 324
- US-A- 5 308 793

## Description

The present invention relates to arrangements for filling holes (such as "VIAS") or the like in surfaces, for example, surfaces which are deposited on semi-conductor wafers or similar substrates.

In European Patent Application No. EP-A-0516344 we discuss the general problems associated with such holes and propose depositing a layer of aluminium or aluminium alloy so as to bridge a recess such as a hole or trench and then subjecting that layer to elevated pressure and elevated temperature to fill the hole. Further developments of this proposal are discussed in European Patent Application No. EP-A-0621980.

In all these proposals, the layer is deposited onto the surface of the substrate using a known deposition process such as chemical vapour deposition or sputtering. As the holes and recesses to be filled become progressively smaller, it has become progressively more difficult to achieve suitable deposition of the aluminium or aluminium alloy layers and it has become even more difficult to achieve satisfactory deposition at the bottom of the holes or recesses of a suitable barrier layer to prevent spiking of the aluminium into the substrate.

From one aspect the invention consists in a method of filling recesses (which term includes trenches, holes or vias) formed in a film or layer deposited on a substrate, comprising laying a metallic foil across the exposed surface of the film to bridge the recesses, heating the foil and applying pressure to the foil, whereby the foil or material therefrom is forced into the recesses to fill them, characterised in that a barrier or lubricating layer is deposited on that surface of the foil which engages the film surface.

The heating step may precede or be simultaneous with the application of pressure.

The pressure may be induced mechanically through a solid or fluid, or it may be applied by creating a pressure drop across the foil. In this latter case a step of creating a pressure drop may include evacuating the recesses either before, during or after the foil has been laid on the surface. The pressure may then be raised on the exposed side of the foil and preferably the initial increase in pressure is sufficiently sudden to seal the foil against the film and hence preclude the pressure in the recesses being raised. Alternatively a mechanical seal could be formed around the periphery of the film.

The foil is preferably a highly-conducting ductile metal such as aluminium, an aluminium alloy, copper or gold.

When the foil is aluminium or aluminium alloy, the barrier or lubrication layer may be Titanium or Titanium Nitride and there may be more than one such layer, for example, there may be a sandwich of Titanium, Titanium Nitride and Titanium.

The foil may be mounted on an organic carrier layer (such as mylar) and the method may further include the step of stripping the carrier layer. Usually the stripping step will be performed prior to the application of pressure, but if, for example, mechanical pressure is to be applied then there may be benefits in retaining the carrier layer at that stage.

One surface of the foil is coated with one or more barrier and/or lubricating layers and these may be Titanium and or Titanium Nitride or a combination thereof. The foil may be mounted on an organic carrier layer on the opposite side to the barrier or lubricating layer or layers if they exist and that organic carrier layer may be a mylar.

It will be appreciated that the use of such foils in the method described above are particularly advantageous, because they can be pre-prepared in accordance with the specific situation in which they are intended to act and are not dependent either upon the environmental conditions within the processing chamber or the nature or topography of the substrate or film on which they are laid.

The invention may be performed in various ways and specific embodiments will now be described with reference to the accompanying drawings, in which:
Figure 1 shows the cross sectional view of a part of a semi-conductor wafer with a foil laid on the top thereof;
Figure 2 shows the cross sectional view of the wafer of Figure 1 after the foil has been subjected to elevated pressure and temperature;
Figure 3 corresponds to Figure 1, but in this case the foil includes a carrier layer and barrier or lubricating layers;
Figure 4 shows the wafer of Figure 3 after the foil has been subjected to elevated temperatures and pressures and the carrier layer has been stripped away.

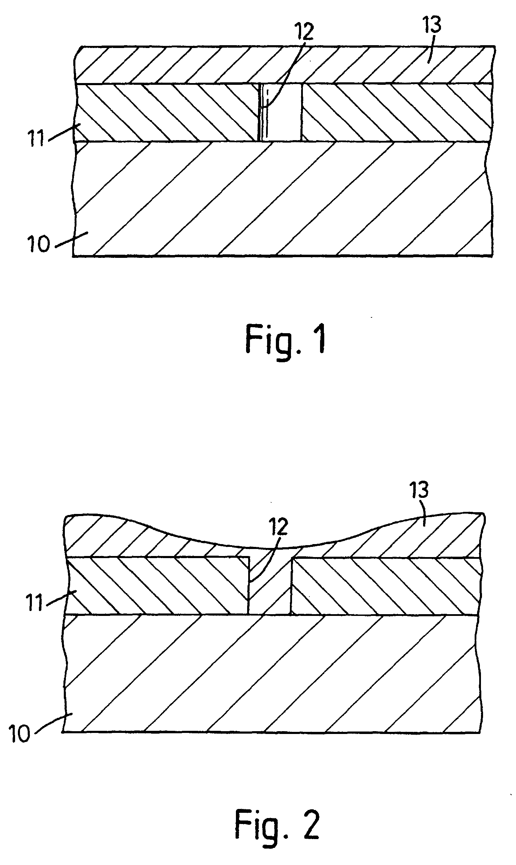

Figure 1 shows a semi-conductor wafer 10 with a pre existing layer or film 11 thereon. The wafer 10 itself may constitute a plurality of layers and/or regions of different properties, to form a semi conductor device, and will be the result of a fabrication process involving a plurality of stages for forming these layers and/or regions. The internal structure of the wafer 10 is not of significance in the present invention, and therefore these layers and/or regions will not be discussed further. The layer 11 has a hole or trench structure 12 therein, and this embodiment of the present invention is particularly concerned with the problem of filling the trench or hole 12 with material so as to allow vertically extending electrical connections to be formed between vertically spaced layers in the structure. In the simplest form of the proposed method, an aluminium foil 13 is laid over the exposed surface of the layer 11 which would normally contain a vast number of holes 12. The fcil 13 bridges all of these holes. Either before, during or after the foil 13 has been laid on the layer 11, the holes 12 are evacuated to a reduced pressure. The foil 13 may then be sealed around its periphery to the layer 11 or preferably pressurised gas is suddenly introduced into the chamber containing the wafer 10 and this will cause the foil to seal against the layer 11 closing off the holes 12 and creating a pressure drop across the thickness of the foil 13. Either before, or simultaneously with, the application of pressure the foil is heated to a temperature below its melting point and this combination of elevated pressure and temperature caused a localised movement of material in the foil so that the holes 12 are filled in the manner shown in Figure 2. In Figures 1 and 2 the barrier or lubricating layer is not shown.

The thickness of the foil will usually be a function of the depth and/or the aspect ratio. Normally, prior to the application of the foil 13 a barrier layer of Titanium or Titanium Nitride may be deposited on the upper surface of the layer 11 and into the hole 12. This can have two functions: first it may prevent spiking of the aluminium or aluminium alloy into the layer 11 or wafer 10 and secondly it may act as a "lubricating" layer which facilitates the movement of aluminium in the foil into the hole 12.

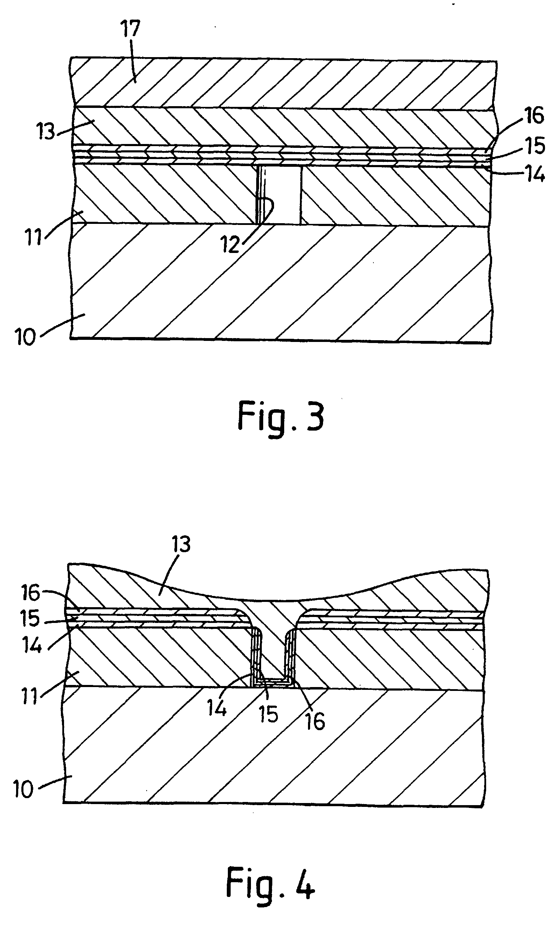

As present day manufacturing techniques require smaller and smaller holes to be filled, the deposition of this barrier layer into the hole 12 can be extremely difficult if not impossible. This situation can be addressed using the arrangement shown in Figures 3 and 4. In this case the aluminium 13 is coated on one side with barrier/lubricating layers 14, 15 and 16 which are made of Titanium/Nitride and Titanium respectively. However, a single layer of Titanium or Titanium Nitride may be used as may be layers of other suitable materials. For convenience the foil 13 is in this case carried on a carrier layer 17, which is preferably organic and may be mylar.

Once the foil 13 is laid onto the layer 11 the process continues as before, although at some stage the carrier layer 17 is stripped away, for example, using an oxygen or hydrogen plasma. As can be seen in Figure 4, the layers 14, 15 and 16 are cornered by the aluminium or alloy flowing into the hole 12 and form a lining of the hole 12. Thus the well known problems of shadowing etc. which occur when one tries to deposit a thin layer of material into an extremely narrow hole are overcome.

The holes of recesses filled may extend through many films or layers and they may form contacts on the layers or to pre-deposited conducting tracks.

As has been mentioned earlier the use of a foil, which is pre-prepared with lubricating or barrier layers, has considerable advantages, because the optimum arrangement of material, thickness etc can be provided irrespective of the process environment and the topography of the surface on which it is deposited.

## Claims

1. A method of filling recesses (12) formed in a film or layer deposited on a substrate (10) comprising laying a metallic foil (13) across the exposed surface of the film or layer to bridge the recesses heating the foil and applying pressure to the foil whereby the foil or material therefrom is forced into the recesses to fill them, **characterised in that** a barrier or lubricating layer (14) is deposited on that surface of the foil which engages the film or layer surface.

2. A method as claimed in claim 1 wherein the step of applying pressure comprises creating a pressure drop across the foil (13).

3. A method as claimed in claim 2 wherein the step of creating a pressure drop includes evacuating the recesses (12) either before, during or after the foil (13) has been laid on the surface.

4. A method as claimed in claim 2 or claim 3 wherein the step of creating a pressure drop includes raising the pressure on the exposed side of the foil (13).

5. A method as claimed in claim 4 wherein the initial increase in pressure is sufficiently sudden to seal the foil (13) against the film or layer (11) and hence preclude the pressure in the recesses (12) being raised.

6. A method as claimed in any one of the preceding claims wherein the foil (13) is aluminium or aluminium alloy.

7. A method as claimed in any one of the preceding claims wherein the barrier or lubrication layer (14) is Titanium or Titanium Nitride.

8. A method as claimed in any one of claims 1 to 7 wherein there is more than one barrier or lubricating layer (14-16).

9. A method as claimed in one of the preceding claims wherein the foil (13) is mounted on or supported by a carrier layer (17) and further including the step of stripping the carrier layer.

## Patentansprüche

1. Verfahren zum Füllen von Ausnehmungen (12), welche auf einer auf einem Substrat (10) abgelagerten dünnen Schicht oder Ablagerung ausgebildet sind, folgendes umfassend, Anordnen einer Metallfolie (13) über der freien Oberfläche der dünnen Schicht oder Ablagerung, um die Ausnehmung zu überbrücken, Heizen der Folie und Beaufschlagen dieser mit Druck, wodurch die Folie oder Material von dieser in die Ausnehmung gedrückt wird um diese aufzufüllen,
**dadurch gekennzeichnet,**
**daß** auf der Seite der Folie, welche die Oberfläche der dünnen Schicht oder Ablagerung berührt, eine Barriere- oder Schmierschicht (14) abgelagert ist.

2. Verfahren nach Anspruch 1, **dadurch gekennzeichnet, daß** der Schritt der Beaufschlagung mit Druck folgendes beinhaltet, Erzeugen eines Druckabfalls über die Folie (13).

3. Verfahren nach Anspruch 2, **dadurch gekennzeichnet, daß** der Schritt der Erzeugung des Druckabfalls folgendes beinhaltet, Evakuieren der Ausnehmung (12) bevor, während oder nachdem die Folie (13) auf die Oberfläche gelegt wird.

4. Verfahren nach Anspruch 2 oder 3, **dadurch gekennzeichnet, daß** der Schritt der Erzeugung des Druckabfalls folgendes beinhaltet, Erhöhen des Druckes auf der freien Seite der Folie (13).

5. Verfahren nach Anspruch 4, **dadurch gekennzeichnet, daß** der anfängliche Druckanstieg ausreichend plötzlich ist, um die Folie (13) gegen die dünne Schicht oder die Ablagerung (11) abzudichten und ein Ansteigen des Druckes in der Ausnehmung (12) zu verhindern.

6. Verfahren nach einem der vorhergehenden Ansprüche, **dadurch gekennzeichnet, daß** die Folie (13) aus Aluminium oder einer Aluminiumlegierung ist.

7. Verfahren nach einem der vorhergehenden Ansprüche, **dadurch gekennzeichnet, daß** die Barriere- oder Schmierschicht (14) aus Titan oder Titannitrid ist.

8. Verfahren nach einem der Ansprüche 1 bis 7, **dadurch gekennzeichnet, daß** mehr als eine Barriere- oder Schmierschicht (14 bis 16) vorgesehen ist.

9. Verfahren nach einem der vorhergehenden Ansprüche, **dadurch gekennzeichnet, daß** die Folie (13) auf einer Trägerschicht (17) befestigt oder von dieser gestützt ist und ferner folgenden Schritt aufweist, Abstreifen der Trägerschicht.

## Revendications

1. Procédé de remplissage de cavités (12) formées dans un film ou une couche déposé sur un substrat (10) comprenant les opérations consistant à mettre en place une feuille métallique (13) à travers la surface exposée du film ou de la couche afin de ponter les cavités, chauffer la feuille et appliquer une pression à la feuille, ce par quoi la feuille ou le matériau de celle-ci est forcé dans les cavités afin de les remplir, **caractérisé par le fait qu'**une couche barrière ou lubrifiante (14) est déposée sur la surface de la feuille qui est en prise avec la surface du film ou de la couche.

2. Procédé selon la revendication 1, dans lequel l'étape d'application de la pression comprend la création d'une chute de pression à travers la feuille (13).

3. Procédé selon la revendication 2, dans lequel l'étape de création d'une chute de pression comprend la mise sous vide des cavités (12) soit avant, soit pendant ou après que la feuille (13) ait été posée sur la surface.

4. Procédé selon la revendication 2 ou la revendication 3, dans lequel l'étape de création d'une chute de pression comprend l'élévation de la pression sur le côté exposé de la feuille (13).

5. Procédé selon la revendication 4, dans lequel l'augmentation initiale de la pression est suffisamment brusque pour sceller la feuille (13) contre le film ou la couche (11) et par là empêcher la pression dans les cavités (12) d'être élevée.

6. Procédé selon l'une quelconque des revendications précédentes, dans lequel la feuille (13) est en aluminium ou en alliage d'aluminium.

7. Procédé selon l'une quelconque des revendications précédentes, dans lequel la couche barrière ou lubrifiante (14) est en Titane ou en Nitrure de Titane.

8. Procédé selon l'une quelconque des revendications 1 à 7, dans lequel il y a plus d'une couche barrière ou lubrifiante (14-16).

9. Procédé selon l'une quelconque des revendications précédentes, dans lequel la feuille (13) est montée sur ou supportée par une couche de support (17) et qui comprend en outre l'étape de détachement de la couche de support.
